# EUROPÄISCHE PATENTSCHRIFT

(11) **EP 3 695 501 B1**
(45) Veröffentlichungstag und Bekanntmachung des Hinweises auf die Patenterteilung: **24.04.2024**
(21) Anmeldenummer: 17816468.7
(22) Anmeldetag: 21.11.2017
(51) Int. Cl.: H02M 7/483, H02M 7/00, H05K 7/14, H05K 7/20

(54) **UMRICHTERANORDNUNG**
CONVERTER ASSEMBLY
DISPOSITIF CONVERTISSEUR

(43) Veröffentlichungstag der Anmeldung: 19.08.2020
(73) Patentinhaber: Siemens Energy Global GmbH & Co. KG, 81739 München (DE)
(72) Erfinder: DÖRING, David, 91058 Erlangen (DE); GIERING, Gerald Franz, 90562 Kalchreuth (DE); RENTSCHLER, Alexander, 64625 Bensheim (DE); WÜRFLINGER, Klaus, 90419 Nürnberg (DE)
(86) Internationale Anmeldenummer: PCT/EP2017/079863
(87) Internationale Veröffentlichungsnummer: WO 2019/101288

(56) Entgegenhaltungen:
- EP-A1- 2 579 438
- EP-A1- 2 825 009
- EP-A1- 2 825 009
- EP-A1- 2 996 238
- WO-A1-2008/106908
- WO-A1-2008/106908
- WO-A1-2016/082863
- WO-A1-2016/082863
- WO-A1-2016/134786
- WO-A1-2016/134786
- WO-A1-2017/044681
- WO-A1-2017/044681
- US-A1- 2012 057 308
- US-A1- 2012 057 308
- Asada Shinsuke ET AL: "Resin Encapsulation Combined with Insulated Metal Baseplate for Improving Power Module Reliability", , 12 May 2016 (2016-05-12), XP055784122, Retrieved from the Internet: URL:https://ieeexplore.ieee.org/stampPDF/g etPDF.jsp?tp=&arnumber=7499375&ref=aHR0cHM 6Ly9pZWVleHBsb3JlLmllZWUub3JnL2RvY3VtZW50L zc0OTkzNzU= [retrieved on 2021-03-10]

## Beschreibung

Die Erfindung betrifft eine Umrichteranordnung mit einem Umrichter, der Umrichterventile aufweist, die jeweils Leistungshalbleiterschalter umfassen.

Eine solche Umrichteranordnung ist beispielsweise aus der WO 2016/155850 A1 bekannt. Der Umrichter der bekannten Umrichteranordnung ist ein sogenannter modularer Mehrstufenumrichter (MMC). Der MMC zeichnet sich insbesondere durch eine modulare Bauweise aus. Die Umrichterventile erstrecken sich jeweils zwischen einem Wechselspannungsanschluss und einem von zwei Gleichspannungspolen des MMC. Die Umrichterventile des MMC weisen jeweils eine Reihenschaltung zweipoliger Schaltmodule auf, wobei jedes Schaltmodul ein- und abschaltbare Leistungshalbleiterschalter sowie einen Energiespeicher, bevorzugt in Form eines Umrichterkondensators, umfasst. Jedes der Schaltmodule ist mittels einer Ansteuereinrichtung einzeln ansteuerbar. Eine an dem Umrichterventil abfallende Spannung ist gleich der Summe von Spannungen, die an den zugehörigen Schaltmodulen abfallen. Mittels des MMC ist eine besonders vorteilhafte stufenförmige Konverterspannung erzeugbar. Die Schaltmodule sind meist als Halbbrückenschaltungen oder als Vollbrückenschaltungen ausgebildet. Das Schaltmodul in Halbbrückenschaltung weist zwei abschaltbare Halbleiterschalter und den Energiespeicher auf, wobei die Halbleiterschalter so mit dem Energiespeicher verschaltet sind, dass an den Ausgangsklemmen des Schaltmoduls eine an dem Energiespeicher abfallende Energiespeicherspannung oder eine Nullspannung erzeugbar ist. Umrichteranordnungen dieser Art werden üblicherweise zur Stromumwandlung, beispielsweise in der Hochspannungsgleichstromübertragung, als auch zur Blindleistungskompensation bzw. Stabilisierung von Wechselspannungsnetzen eingesetzt. In solchen Fällen ist der Umrichterarm beispielsweise zwischen zwei Wechselspannungsanschlüssen des Umrichters angeordnet.

Ein weiteres Beispiel einer artgemäßen Umrichteranordnung ist aus der EP 0 299 275 B1 bekannt. Dort ist ein Umrichter beschrieben, dessen Umrichterventile Thyristoren umfassen, die in Gehäusen in Form von Modulen angeordnet sind. Die Module sind zu Ventiltürmen zusammengefasst, die in einer Ventilhalle montiert sind.

Die Ventilhalle befindet sich auf einem Erdpotenzial. Im Betrieb des Stromrichters sind die Thyristoren der Halbleiterschaltung demgegenüber auf unterschiedlichen Hochspannungspotenzialen, so dass die Thyristoren der Halbleiterschaltung gegenüber einander und der Ventilhallenwand elektrisch isoliert werden müssen. Dies geschieht üblicherweise durch Bereitstellung von genügend Luftstrecke. Die aus der Literatur bekannten Minimalabstände betragen 1 - 10 mm/kV. Dies führt bei hohen Spannungsdifferenzen, die an der Halbleiterschaltung anliegen, zu notwendigerweise großen Abmessungen der Ventilhalle. Üblicherweise betragen die Breite und die Länge der Ventilhalle bis zu mehreren Metern. Beispielsweise sind bei einer Hochspannungsgleichstromübertragungsanlage mit einer Spannung von 1,4 MV Abstände von bis zu 14 m zwischen verschiedenen Hochspannungskomponenten und einer Hallenwand notwendig.

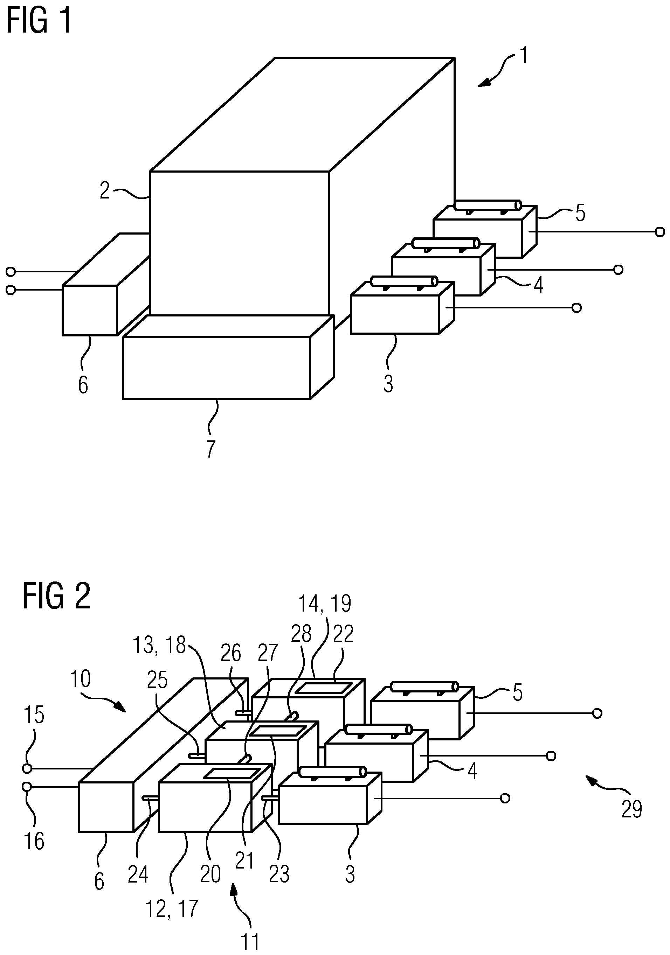

In der Figur 1 ist der schematische Aufbau einer solchen Ventilhalle 1 gezeigt, in der ein Umrichter der artgemäßen Umrichteranordnung angeordnet sein kann.

Die Ventilhalle 1 der Figur 1 weist einen Grundriss von ca. 40 m x 60 m auf. Die darin angeordneten Ventiltürme weisen einen Abstand von ca. 15 m zu der auf Erdpotenzial liegenden Wand 2 der Ventilhalle auf. Leitungen, die den Umrichter mit wechselspannungsseitigen Transformatoren 3, 4 und 5 verbinden, sind aus der Ventilhalle 1 mittels Hochspannungsdurchführungen (in Figur 1 nicht explizit dargestellt) herausgeführt. Entsprechend verbinden weitere Leitungen, die mittels weiterer Hochspannungsdurchführungen aus der Ventilhalle 1 herausgeführt sind, den Umrichter mit gleichspannungsseitigen Anlangenteilen 6, wie beispielsweise Drosseln oder Schaltanlagen. Eine Kühlanlage 8 zur Kühlung der sich in der Ventilhalle 1 befindenden Komponenten der Umrichteranordnung 1 befindet sich in einem separaten Container. Die Ventilhalle 1 dient dem Schutz der Leistungselektronik des Umrichters hinsichtlich Feuchtigkeit, Luftqualität und Temperatur und bedarf üblicherweise zusätzlich großer Luftfilter und Kühler außerhalb der Ventilhalle. Ferner benötigt jeder Leistungshalbleiterschalter einen eigenen Wasserkühlungsanschluss, der an einen Pumpenkreislauf angeschlossen ist.

Ein Umrichter für Unterseeanwendungen ist aus der EP 2 825 009 A1 bekannt. Bei dem bekannten Umrichter handelt es sich um einen modularen Mehrstufenumrichter (MMC), der aus Leistungshalbleitermodulen aufgebaut ist. Die Leistungshalbleitermodule des Umrichters sind in einem gemeinsamen Gehäuse angeordnet, dass mit einer Kühlflüssigkeit gefüllt ist.

Ein Behältnis für einen Stromrichter in marinen Anwendungen ist aus der US 2012/0057308 A1 bekannt. Das Behältnis ist doppelwandig, wobei ein entsprechend gebildeter Zwischenraum mit einem Isoliermedium angeordnet ist.

In der WO 2016/082863 A1 ist ein Stromrichterventil beschrieben, bei dem das Stromrichterventil in einer inneren Aufnahme untergebracht ist, die wiederum innerhalb einer äußeren Aufnahme angeordnet ist. Zwischen den beiden Aufnahmen ist ein Isolationsmaterial angeordnet.

Die Aufgabe der Erfindung besteht darin, eine artgemäße Umrichteranordnung anzugeben, die möglichst einfach und kostengünstig bei der Herstellung, der Inbetriebnahme und in Betrieb ist.

Die Erfindung löst diese Aufgabe durch eine Vorrichtung gemäß Anspruch 1. Bevorzugte Ausführungsformen werden in den abhängigen Ansprüchen beschrieben.

Die Aufgabe wird bei einer artgemäßen Umrichteranordnung nach Anspruch 1 gelöst.

Demnach wird der Umrichter der Umrichteranordnung bzw. dessen Umrichterventile mittels eines Isolierfluids elektrisch gegenüber dem Erdpotenzial isoliert. Zudem sind die Leistungshalbleiterschalter des Umrichters in wenigstens einem fluiddichten Kapselungsgehäuse angeordnet, so dass sie eine oder mehrere modulare Umrichtereinheiten bilden. Die Umrichtereinheiten sind im Vergleich zur bekannten Ventilhalle transportierbar. Somit lässt sich die Inbetriebnahme der Umrichteranordnung vorteilhaft vereinfachen. Es ist beispielsweise denkbar, dass jedes Umrichterventil mit dem zugeordneten Kapselungsgehäuse eine modulare Umrichtereinheit ausbildet. Die modularen Umrichtereinheiten können miteinander unter Ausbildung des Umrichters verbunden werden. Das Kaplselungsgehäuse weist aufgrund der Fluidisolation vorteilhafterweise wesentlich kleinere Abmessungen als die bekannte Ventilhalle auf. Beispielsweise können die Isolationsabstände auf ca. ein Drittel in besonders günstigen Fällen sogar um den Faktor zehn reduziert werden. Der einfache Aufbau und kleinere Abmessungen erlauben vorteilhaft einen Kostenvorteil gegenüber den bisher bekannten Lösungen.

Insbesondere können alle Leistungshalbleiterschalter in einem oder mehreren Kapselungsgehäusen untergebracht sein. Das oder die Kapselungsgehäuse können vollständig mit dem Isolierfluid gefüllt sein.

Erfindungsgemäß ist das wenigstens eine Kapselungsgehäuse flüssigkeitsdicht isoliert, wobei das Isolierfluid eine Isolierflüssigkeit ist. Ein flüssigkeitsdichtes Kapselungsgehäuse ist einfacher herzustellen und dadurch kostengünstiger als ein entsprechendes gasdichtes Kapselungsgehäuse. Die Isolierabstände können bei der Verwendung einer Isolierflüssigkeit gegenüber einer Gasisolierung vorteilhaft weiter verkleinert werden.

Erfindungsgemäß umfasst die Isolierflüssigkeit ein Ester. Die Isolierflüssigkeit ist beispielsweise eine Esterflüssigkeit. Ester haben sich als gute elektrische Isolatoren erwiesen.

Gemäß einer Ausführungsform der Erfindung sind die Leistungshalbleiterschalter Thyristoren. Der Umrichter ist beispielsweise ein netzgeführter Umrichter mit einem Stromzwischenkreis (LCC).

Gemäß einer weiteren Ausführungsform sind die Leistungshalbleiterschalter ein- und abschaltbare Leistungshalbleiterschalter. Dies können beispielsweise IGBTs, IGCTs oder dergleichen sein. Mit der Verwendung der abschaltbaren Leistungshalbleiterschalter kann ein selbstgeführter Umrichter bereitgestellt sein.

Es sind jedoch auch Varianten denkbar, bei denen der Umrichter sowohl Thyristoren als auch abschaltbare Leistungshalbleiterschalter umfasst.

Gemäß einer Ausführungsform der Erfindung weist jeder der Umrichterventile eine Reihenschaltung von zweipoligen Schaltmodulen auf, wobei jedes Schaltmodul wenigstens zwei Leistungshalbleiterschalter sowie einen Energiespeicher umfasst, wobei zumindest einige der Schaltmodule in dem wenigstens einen Kapselungsgehäuse angeordnet sind. Auf diese Weise ist eine zweistufige Modulbauweise des Umrichters bereitgestellt, bei der die Umrichterventile mit den Schaltmodulen modular aufgebaut sind (1. Stufe der Modularisierung), und der Umrichter des Weiteren die modularen Umrichtereinheiten aufweist (2. Stufe der Modularisierung). Der Umrichter kann zum Beispiel ein eingangs beschriebener modularer Mehrstufenumrichter sein. Dabei können die Umrichterventile Schaltmodule mit Halbbrückenschaltungen und/oder mit Vollbrückenschaltungen umfassen, wobei auch andere Schaltmodul-Topologien denkbar sind.

Erfindungsgemäß umfasst die Umrichteranordnung mehrere modulare Umrichtereinheiten, wobei zumindest einige der modularen Umrichtereinheiten miteinander mittels gasisolierten oder flüssigkeitsisolierten elektrischen Leitungen unter Ausbildung des Umrichters der Umrichteranordnung, beispielsweise eines modularen Mehrstufenumrichters, verbindbar sind. Durch die Verwendung der gasisolierten oder flüssigkeitsisolierten elektrischen Leitungen zur Verbindung der einzelnen Umrichtereinheiten kann vorteilhaft auf die Verwendung von Hochspannungsdurchführungen verzichtet werden. Dies senkt die Kosten der Umrichteranordnung. Das Isoliermedium der Leitungen ist bevorzugt gleich mit dem Isoliermedium in dem Kapselungsgehäuse.

Erfindungsgemäß umfasst die Umrichteranordnung ferner wenigstens eine weitere Hochspannungskomponente, wobei die modulare Umrichtereinheit mittels wenigstens einer gasisolierten oder flüssigkeitsisolierten elektrischen Leitung mit der Hochspannungskomponente elektrisch verbindbar ist. Demnach werden weitere Komponenten der Umrichteranordnung, wie beispielsweise Transformatoren oder Schaltanlagen, mittels gleichartiger Leitungen mit dem Umrichter verbunden, wie die modularen Umrichtereinheiten untereinander. Dadurch kann eine weitere Vereinfachung des Aufbaus der Umrichteranordnung erreicht werden.

Bevorzugt umfasst die modulare Umrichtereinheit, insbesondere jede der Umrichtereinheiten, eine Kühlvorrichtung mit einer Kühlflüssigkeit zur Kühlung der Leistungshalbleiter, wobei die Kühlflüssigkeit die Isolierflüssigkeit ist. Hierbei wird die Isolierflüssigkeit zur Kühlung der leistungselektronischen Komponenten des Umrichters genutzt. Auf diese Weise kann vorteilhaft auf eine aufwändige externe Kühlvorrichtung verzichtet werden. Besonders bevorzugt wird eine Konvektionsbewegung der Isolierflüssigkeit für den Wärmetransport genutzt. Damit kann auf einen aktiven Pumpkreislauf verzichtet werden (passive Isolierstoffbewegung). Die thermische Leitfähigkeit und Speicherfähigkeit der Isolierflüssigkeit kann insbesondere für den Wärmetransport von den Leistungshalbleiterschaltern beispielsweise zum Kapselungsgehäuse und nach außen genutzt werden. Es ist jedoch auch eine aktive Isolierstoffbewegung mittels geeigneter Pumpen denkbar.

Gemäß einer Ausführungsform der Erfindung umfasst die Kühlvorrichtung einen Radiator zum Abführen von Wärme, der außen an dem wenigstens einem Kapselungsgehäuse angeordnet ist. Der Radiator ist vorzugsweise aus einem gut Wärme leitendem Material, so dass die von der Isolierflüssigkeit abgegebene Wärme an die Umgebung der Umrichteranordnung weiter geleitet werden kann.

Die Erfindung soll im Folgenden anhand der Figur 2 weiter erläutert werden.

Figur 2 zeigt ein Ausführungsbeispiel einer erfindungsgemäßen Umrichteranordnung in einer schematischen Darstellung.

Im Einzelnen ist in Figur 2 eine Umrichteranordnung 10 dargestellt. Die Umrichteranordnung 10 umfasst einen Umrichter 11. Der Umrichter 11 umfasst drei modulare Umrichtereinheiten 12, 13 und 14. Die modularen Umrichtereinheiten 12-14 sind in diesem Beispiel, müssen aber im Allgemeinen nicht gleichartig aufgebaut sein. Jede Umrichtereineheit umfasst zwei Umrichterventile des Umrichters, die sich jeweils zwischen einem ersten oder einem zweiten Gleichspannungspol 15 bzw. 16 des Umrichters und einem Wechselspannungsanschluss des Umrichters zum Verbinden des Umrichters mit wechselspannungsseitigen Komponenten der Umrichteranordnung erstrecken. In dem in Figur 2 dargestellten Ausführungsbeispiel sind die Umrichtereinheiten wechselspannungsseitig mit Transformatoren 3-5 verbunden.

Jede modulare Umrichtereinheit 12-14 umfasst ein flüssigkeitsdichtes Kapselungsgehäuse 17, 18 bzw. 19. Jedes Kapselungsgehäuse 17-19 ist mit einer Esterflüssigkeit gefüllt. Die Esterflüssigkeit dient einerseits zur elektrischen Isolierung der leistungselektronischen Komponenten der Umrichterventile, die im Kapselungsgehäuse angeordnet ist. Anderseits dient die Esterflüssigkeit zum Wärmetransport und damit zur Kühlung der Leistungshalbleiterschalter des Umrichters 11. Jedes Kapselungsgehäuse 17-19 umfasst ferner einen Radiator 20, 21 bzw. 22, der den Wärmetransport nach außen verbessert.

Elektrische Verbindungen zwischen den Umrichtereinheiten 12-14 untereinander sowie mit den gleichspannungsseitigen Komponenten 6 (z.B. Drosseln oder Schaltanlagen) und mit den wechselspannungsseitigen Komponenten 3-5 (im dargestellten Beispiel Transformatoren), sind mittels fluidisolierten elektrischen Leitungen 23-28 realisiert. Aus Gründen der Übersichtlichkeit sind in Figur 2 nur einigen aber nicht alle elektrischen Verbindungen der Umrichteranordnung 10 grafisch dargestellt. Die Transformatoren 3-5 weisen jeweils ein Transformatorgehäuse auf, das flüssigkeitsdicht ist. Die elektrische Isolation innerhalb der Transformatorgehäuse kann durch eine Isolierflüssigkeit wie beispielsweise ein Isolieröl oder eine Esterflüssigkeit bereitgestellt sein.

Die Umrichteranordnung weist einen Anschluss 29 zum Anschließen der Umrichteranordnung 10 an ein dreiphasiges Wechselspannungsnetz auf.

## Patentansprüche

1. Umrichteranordnung (10) mit einem Umrichter (11), der Umrichterventile aufweist, die jeweils Leistungshalbleiterschalter umfassen, **dadurch gekennzeichnet, dass** die Umrichteranordnung (10) drei modulare Umrich-tereinheiten (12-14) umfasst, wobei jede Umrichtereineheit genau zwei Umrichterventile des Umrichters umfasst, die sich jeweils zwischen einem ersten oder einem zweiten Gleichspannungspol (15, 16) des Umrichters und einem Wechselspannungsanschluss des Umrichters zum Verbinden des Umrichters mit wechselspannungsseitigen Komponenten der Umrichteranordnung erstrecken, wobei zumindest einige der modularen Umrichtereinheiten (12-14) miteinander mittels gasisolierten oder flüssigkeitsisolierten elektrischen Leitungen (27,28) unter Ausbildung des Umrichters (11) verbunden sind, wobei ein separates fluiddichtes Kapselungsgehäuse (17-19) für jede der modularen Umrichtereinheiten vorgesehen ist, in dem zumindest einige der Leistungshalbleiterschalter unter Ausbildung der jeweiligen modularen Umrichtereinheit (12-14) angeordnet sind, und das Kapselungsgehäuse (17-19) zum elektrischen Isolieren der darin angeordneten Leistungshalbleiterschalter mit einem elektrisch isolierenden Isolierfluid gefüllt ist, wobei das wenigstens eine Kapselungsgehäuse (17-19) flüssigkeitsdicht isoliert ist und das Isolierfluid eine Isolierflüssigkeit ist, die ein Ester umfasst, wobei die Umrichteranordnung (10) ferner wenigstens eine weitere Hochspannungskomponente (3-6) umfasst, die ein Transformator oder eine Schaltanlage ist, wobei die modulare Umrichtereinheit mittels wenigstens einer gasisolierten oder flüssigkeitsisolierten elektrischen Leitung (23-26) mit der Hochspannungskomponente (3-6) elektrisch verbunden ist.

2. Umrichteranordnung (10) nach Anspruch 1, wobei die Leistungshalbleiterschalter Thyristoren sind.

3. Umrichteranordnung (10) nach einem der vorangehenden Ansprüche 1 bis 2, wobei die Leistungshalbleiterschalter einund abschaltbare Leistungshalbleiterschalter sind.

4. Umrichteranordnung (10) nach Anspruch 3, wobei jeder der Umrichterventile eine Reihenschaltung von zweipoligen Schaltmodulen aufweist, wobei jedes Schaltmodul wenigstens zwei Leistungshalbleiterschalter sowie einen Energiespeicher umfasst, wobei zumindest einige der Schaltmodule in dem wenigstens einen Kapselungsgehäuse angeordnet sind.

5. Umrichteranordnung (10) nach einem der vorangehenden Ansprüche 2 bis 4, wobei die modulare Umrichtereinheit (12-14) ferner eine Kühlvorrichtung mit einer Kühlflüssigkeit zur Kühlung der Leistungshalbleiter umfasst, wobei die Kühlflüssigkeit die Isolierflüssigkeit ist.

6. Umrichteranordnung (10) nach Anspruch 5, wobei die Kühlvorrichtung einen Radiator (20-22) zum Abführen von Wärme umfasst, der außen an dem wenigstens einem Kapselungsgehäuse (17-19) angeordnet ist.

## Claims

1. Converter assembly (10) comprising a converter (11), which has converter valves, which each comprise power semiconductor switches, **characterized in that** the converter assembly (10) comprises three modular converter units (12-14), wherein each converter unit comprises exactly two converter valves of the converter which extend in each case between a first or a second DC voltage pole (15, 16) of the converter and an AC voltage terminal of the converter for connecting the converter to components of the converter assembly that are on the AC voltage side, wherein at least some of the modular converter units (12-14) are connected to one another by means of gas-insulated or liquid-insulated electrical lines (27, 28) to form the converter (11), wherein provision is made of a separate fluid-tight encapsulation housing (17-19) for each of the modular converter units, in which at least some of the power semiconductor switches are arranged to form the respective modular converter unit (12-14), and the encapsulation housing (17-19) is filled with an electrically insulating insulation fluid in order to electrically insulate the power semiconductor switches arranged in said encapsulation housing, wherein the at least one encapsulation housing (17-19) is insulated in a liquid-tight manner and the insulation fluid is an insulation liquid comprising an ester, wherein the converter assembly (10) furthermore comprises at least one further high-voltage component (3-6) which is a transformer or a switchgear installation, wherein the modular converter unit is electrically connected to the high-voltage component (3-6) by means of at least one gas-insulated or liquid-insulated electrical line (23-26) .

2. Converter assembly (10) according to Claim 1, wherein the power semiconductor switches are thyristors.

3. Converter assembly (10) according to either of the preceding Claims 1 and 2, wherein the power semiconductor switches are power semiconductor switches capable of being turned on and off.

4. Converter assembly (10) according to Claim 3, wherein each of the converter valves has a series connection of two-pole switching modules, wherein each switching module comprises at least two power semiconductor switches and also an energy store, wherein at least some of the switching modules are arranged in the at least one encapsulation housing.

5. Converter assembly (10) according to any of the preceding Claims 2 to 4, wherein the modular converter unit (12-14) furthermore comprises a cooling device having a cooling liquid for cooling the power semiconductors, wherein the cooling liquid is the insulation liquid.

6. Converter assembly (10) according to Claim 5, wherein the cooling device comprises a radiator (20-22) for dissipating heat, said radiator being arranged on the exterior of the at least one encapsulation housing (17-19).

## Revendications

1. Dispositif (10) convertisseur comprenant un convertisseur (11), qui a des soupapes de convertisseur, qui comprennent chacune des interrupteurs à semi-conducteurs de puissance, **caractérisé en ce que**
le dispositif (10) convertisseur comprend trois unités (12 à 14) modulaires de convertisseur, dans lequel chaque unité de convertisseur comprend exactement deux soupapes de convertisseur du convertisseur, qui s'étendent respectivement entre un premier ou un deuxième pôle (15, 16) de tension continue du convertisseur et une borne de tension alternative du convertisseur pour la connexion du convertisseur à des composants du côté de la tension alternative du dispositif convertisseur, dans lequel au moins certaines des unités (12 à 14) modulaires de convertisseur sont connectées entre elles avec formation du convertisseur (11) au moyen de lignes (27, 28) électriques à isolation par du gaz ou à isolation par du liquide, dans lequel il est prévu un boîtier (17 à 19) de blindage distinct et étanche au fluide pour chacune des unités modulaires de convertisseur, dans lequel au moins certains des interrupteurs à semi-conducteur de puissance sont disposés avec formation de l'unité (12 à 14) modulaire de convertisseur respective, et le boîtier (17 à 19) de blindage est, pour l'isolement électrique des interrupteurs à semi-conducteurs de puissance, qui y sont disposés, rempli d'un fluide isolant électriquement, dans lequel le au moins un boîtier (17 à 19) de blindage est isolé d'une manière étanche au liquide et le fluide isolant est un liquide isolant, qui comprend un ester, dans lequel le dispositif (10) convertisseur comprend en outre au moins un autre composant (3 à 6) de haute tension, qui est un transformateur ou une installation de distribution, dans lequel l'unité modulaire de convertisseur est connectée électriquement au composant (3 à 6) de haute tension au moyen d'au moins une ligne (23 à 26) électrique à isolation par du gaz ou à isolation par du liquide.

2. Dispositif (10) convertisseur suivant la revendication 1, dans lequel les interrupteurs à semi-conducteurs de puissance sont des thyristors.

3. Dispositif (10) convertisseur suivant l'une des revendications 1 à 2 précédentes, dans lequel les interrupteurs à semi-conducteurs de puissance sont des interrupteurs à semi-conducteurs de puissance pouvant être fermés et ouverts.

4. Dispositif (10) convertisseur suivant la revendication 3, dans lequel chacune des soupapes de convertisseur a un circuit série de deux modules bipolaires de coupure, dans lequel chaque module de coupure comprend au moins deux interrupteurs à semi-conducteur de puissance ainsi qu'un accumulateur d'énergie, dans lequel au moins certains des modules de coupure sont disposés dans le au moins un boîtier de blindage.

5. Dispositif (10) convertisseur suivant l'une des revendications 2 à 4 précédentes, dans lequel l'unité (12 à 14) modulaire de convertisseur comprend en outre un dispositif de refroidissement ayant un liquide de refroidissement pour le refroidissement des semi-conducteurs de puissance, dans lequel le liquide de refroidissement est le liquide isolant.

6. Dispositif (10) convertisseur suivant la revendication 5, dans lequel le dispositif de refroidissement comprend un radiateur (20 à 22) d'évacuation de la chaleur, qui est monté à l'extérieur sur le au moins un boîtier (17 à 19) de blindage).
